(19) Europäisches Patentamt
European Patent Office
Office européen des brevets

(11) **EP 2 829 165 B1**

(12) **EUROPÄISCHE PATENTSCHRIFT**

(45) Veröffentlichungstag und Bekanntmachung des Hinweises auf die Patenterteilung:
**17.07.2019 Patentblatt 2019/29**

(51) Int Cl.:
*H05K 13/00* *(2006.01)*   *H05K 13/08* *(2006.01)*
*G06Q 10/00* *(2012.01)*

(21) Anmeldenummer: **13722709.6**

(22) Anmeldetag: **24.04.2013**

(86) Internationale Anmeldenummer:
**PCT/EP2013/058523**

(87) Internationale Veröffentlichungsnummer:
**WO 2014/005741 (09.01.2014 Gazette 2014/02)**

(54) **ZUORDNUNG VON LEITERPLATTEN AUF BESTÜCKUNGSLINIEN**

ALLOCATION OF PRINTED CIRCUIT BOARDS ON FITTING LINES

AFFECTATION DE CARTES DE CIRCUITS IMPRIMES SUR DES LIGNES DE MONTAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **06.07.2012 DE 102012211814**

(43) Veröffentlichungstag der Anmeldung:
**28.01.2015 Patentblatt 2015/05**

(73) Patentinhaber: **Siemens Aktiengesellschaft 80333 München (DE)**

(72) Erfinder:
• **PFAFFINGER, Alexander 81739 München (DE)**
• **ROYER, Christian 85521 Ottobrunn (DE)**

(56) Entgegenhaltungen:
**EP-A1- 0 478 360    EP-A1- 0 478 361**

• **EPO: "Mitteilung des Europäischen Patentamts vom 1. Oktober 2007 über Geschäftsmethoden = Notice from the European Patent Office dated 1 October 2007 concerning business methods = Communiqué de l'Office européen des brevets,en date du 1er octobre 2007, concernant les méthodes dans le domaine des activités", JOURNAL OFFICIEL DE L'OFFICE EUROPEEN DES BREVETS.OFFICIAL JOURNAL OF THE EUROPEAN PATENT OFFICE.AMTSBLATTT DES EUROPAEISCHEN PATENTAMTS, OEB, MUNCHEN, DE, Bd. 30, Nr. 11, 1. November 2007 (2007-11-01), Seiten 592-593, XP007905525, ISSN: 0170-9291**
• **HANS -OTTO G?NTHER ET AL: "Workload planning in small lot printed circuit board assembly", OR SPECTRUM, vol. 19, no. 2, 1 June 1997 (1997-06-01), pages 147-157, XP055085604, ISSN: 0171-6468, DOI: 10.1007/BF01545517**

**Beschreibung**

Die vorliegende Erfindung betrifft ein Verfahren zur Zuordnung von Leiterplatten auf Bestückungslinien zur Bestückung der Leiterplatten oder anderen Baugruppen mit Bauelementen. Weiterhin betrifft die Erfindung eine Steuereinrichtung für eine Fertigungs- oder Montagelinie zur Bestückung von Leiterplatten mit Bauelementen. Außerdem betrifft die Erfindung ein Computerprogrammprodukt und ein computerlesbares Medium.

Insbesondere im Bereich der Elektronikproduktion werden zu fertigende Leiterplatten bzw. Baugruppen auf SMT-Bestückungslinien durch Oberflächenmontage (surface mounted technology, SMT) hergestellt. Auf Grund von technischen Restriktionen kann aber nicht jede Leiterplatte auf jeder Bestücklinie gefertigt werden. Die Leiterplatten besitzen auf den Bestückungslinien meist auch unterschiedliche Produktionszeiten. Zudem dürfen die maximalen Produktionszeitkapazitäten der Bestückungslinien nicht überschritten werden.

DE 10 2009 013 353 B3 zeigt ein Verfahren zur Rüstung einer solchen Bestückungslinie.

EP 0 478 361 A1 betrifft ein Verfahren zur Bestückung von Leiterplatten mit Bauelementen, wobei eine Produktionshäufigkeit eines Leiterplattentyps und die zur Produktion erforderlichen Bauelemente berücksichtigt werden.

EP 0 478 360 A1 betrifft ein weiteres Bestückungsverfahren, bei dem versucht wird, eine Einrichtungszeit für eine Produktionslinie zur Bestückung der Leiterplatten zu verbessern.

"Workload planning in small lot printed circuit board assembly", Hans-Otto Günther et al. OR Spectrum Bd. 19, Nr. 2, 1. Juni 1997, Seiten 147-157, betrifft die Zusammenstellung eines Tagesprogramms für eine Kleinserienmontage von Leiterplatten.

Die Zuordnung von Leiterplatten auf Bestücklinien eines Bestückungssystems erfolgt üblicherweise manuell oder halbautomatisch, basierend auf Erfahrungswerten oder Heuristiken. Dabei hat es sich in der Praxis gezeigt, dass immer wieder unausgewogene Zuordnungen getroffen werden, die eine hohe Auslastung einer Komponente einer Bestückungslinie mit einer niedrigen Auslastung einer anderen Komponente bedingen, so dass das Bestückungssystem nicht optimal genutzt werden kann.

Es ist Aufgabe der vorliegenden Erfindung, eine verbesserte Technik zur Zuordnung von Leiterplatten auf Bestückungslinien bereitzustellen.

Die Erfindung löst diese Aufgabe mittels eines Verfahrens, eines Computerprogrammprodukts und einer Steuereinrichtung mit den Merkmalen der unabhängigen Ansprüche. Unteransprüche geben bevorzugte Ausführungsformen wieder.

Ein Bestückungssystem umfasst mehrere Bestückungslinien zur Bestückung von Leiterplatten mit elektronischen Bauteilen. Ein Verfahren zur Zuordnung von Leiterplatten an die Bestückungslinien umfasst Schritte des Erfassens von Anforderungen zur Bestückung mehrerer Leiterplatten mit jeweils zugeordneten Bauteilen und des Zuordnens der Leiterplatten an Bestückungslinien unter vorbestimmten Vorgaben mittels ganzzahliger linearer Programmierung. Anschließend werden Rüstfamilien für die Bestückungslinien auf der Basis der Zuordnung bestimmt und die Zuordnung wird so lange wiederholt, bis ein Kriterium eine vorbestimmte Schwelle erreicht hat, wobei das Kriterium auf der Basis der Anzahlen Rüstfamilien der Bestückungslinien gebildet ist.

Dabei ist eine Rüstfamilie bestimmt als eine Menge von Leiterplatten, die auf einer Bestückungslinie bestückt werden können, ohne die Menge der Bauteiltypen zu ändern, die an der Bestückungslinie für die Bestückung bereit gehalten sind. Die Menge der an der Bestückungslinie bereit gehaltenen Bauteiltypen wird auch Rüstung genannt. Es wird üblicherweise davon ausgegangen, dass stets ausreichend viele Bauteile jedes Bauteiltyps an der Bestückungslinie bereit gehalten sind.

Üblicherweise sind einer Bestückungslinie mehr Leiterplatten zugeordnet als von einer Rüstfamilie umfasst sein können, da an der Bestückungslinie nicht beliebig viele Bauteiltypen bereit gehalten werden können. Die Bestückungslinie wird daher gelegentlich einem Rüstwechsel unterzogen, bei dem die Rüstung für eine erste Rüstfamilie gegen die Rüstung für eine zweite Rüstfamilie gewechselt wird. Je seltener diese Rüstwechsel sind und je weniger Bauteiltypen bei einem Rüstwechsel gewechselt werden müssen, desto kostengünstiger kann das Bestückungssystem betrieben werden.

Es hat sich gezeigt, dass die Anzahl der insgesamt im Bestückungssystem verwendeten Rüstfamilien einen realistischeren Qualitätsindikator als beispielsweise eine Bauelementevarianz einer Bestückungsline darstellen kann. Die Bauelementevarianz einer Bestückungslinie ist dabei durch die Anzahl unterschiedlicher Bauteile gegeben, die auf eine der Leiterplatten zu bestücken sind, die der Bestückungslinie zugeordnet sind. Das Verfahren kann daher Zuordnungen von Leiterplatten an Bestückungslinien bestimmen, die eine verbesserte Auslastung des gesamten Bestückungssystems erlauben.

Außerdem kann das Verfahren flexibel an tatsächliche Gegebenheiten oder Wünsche eines Betreibers des Bestückungssystems angepasst werden. Durch die Verwendung ganzzahliger linearer Programmierung kann ein globaler Optimierungsansatz realisiert werden. Eine Erweiterung des Verfahrens ist leicht möglich. Laufzeitumgebungen zur Ausführung einer Optimierung mittels ganzzahliger linearer Programmierung sind in Form von kommerziellen Produkten wie beispielsweise Ilog oder Xpress verfügbar. Derartige sogenannte Standard-Solver werden laufend verbessert, so dass zu erwarten ist, dass die Zuordnung mittels des beschriebenen Verfahrens in Zukunft noch schneller und/oder weiter optimiert durchführbar ist.

Das beschriebene Verfahren kann eine sehr gute Zuordnung von Leiterplatten zu Bestückungslinien innerhalb relativ kurzer Laufzeit erlauben. Das Verfahren kann im Vergleich mit anderen Optimierungsansätzen bezüglich Ergebnisgüte oder erforderlicher Laufzeit verbesserte Resultate erbringen. Außerdem lassen sich mittels des Verfahrens Zuordnungen von Leiterplatten zu Bestückungslinien finden, die ausgeglichene Anzahlen von Rüstfamilien und die Bildung einer gesteigerten Anzahl konstanter Wechseltische erlauben.

Für die Bestimmung der Rüstfamilien wird bevorzugt ein von der ganzzahligen Linearen Programmierung separates Verfahren aufgerufen. Durch die Trennung von ganzzahliger linearer Programmierung und Bestimmung des Bewertungskriteriums kann vermieden werden, dass die ganzzahlige lineare Programmierung ein zu komplexes Zuordnungsproblem zu bearbeiten hat und deshalb entweder sehr lange zur Erstellung einer Zuordnung braucht oder die erstellte Lösung weniger gut ist.

Ist der Solver jedoch ausreichend leistungsfähig, so kann die Zuordnung in einer anderen Ausführungsform mittels ganzzahliger linearer Programmierung auch direkt bezüglich einer Minimierung der Anzahl Rüstfamilien für die Bestückungslinien erfolgen.

In einer Ausführungsform umfasst das Kriterium die Bedingung, dass die Anzahl von Rüstfamilien jeder Bestückungslinie größer als eine vorbestimmte Schwelle ist. Ein Konvergieren der Optimierung mittels ganzzahliger linearer Programmierung kann dadurch beschleunigt sein.

In einer weiteren Ausführungsform umfasst das Kriterium die Bedingung, dass die Anzahl der Rüstfamilien jeder Bestückungslinie kleiner als eine vorbestimmte Schwelle ist. Eine übermäßig hohe Auslastung einer der Bestückungslinien kann dadurch verhindert werden.

In unterschiedlichen Varianten können eine oder beide der oben genannten vorbestimmten Schwellen individuell für eine oder mehrere der Bestückungslinien vorbestimmbar sein. Ein Erfahrungswert für sich als sinnvoll erwiesene Schwelle kann dadurch berücksichtigt werden.

In einer Ausführungsform umfasst das Kriterium die Bedingung, dass Unterschiede zwischen den Anzahlen von Rüstfamilien jeder Bestückungslinie unter einer vorbestimmten Schwelle liegen. Eine Zuordnung von Leiterplatten an Bestückungslinien kann somit dahingehend optimiert werden, dass die Bestückungslinien möglichst gleiche Anzahlen von Rüstfamilien haben. Durch Vergrößern oder Verkleinern der vorbestimmten Schwelle lässt sich in verbesserter Weise ein Kompromiss aus hoher Qualität der Zuordnung und Laufzeit des Verfahrens wählen. Die Schwelle kann in einer Ausführungsform auch Null betragen. In einer anderen Ausführungsform kann das Kriterium auch einen quantifizierten Unterschied zwischen den Anzahlen von Rüstfamilien der einzelnen Bestückungslinien umfassen. In diesem Fall kann die Zuordnung von Leiterplatten zu Bestückungslinien in wiederholten Iterationen des Verfahrens auch bezüglich eines möglichst geringen Unterschieds optimiert werden.

In noch einer Ausführungsform wird das Zuordnen von Leiterplatten einer Rüstfamilie zu einer Bestückungslinie verhindert, falls der Rüstfamilie eine geringe Anzahl Leiterplatten oder ein geringer Spurverbrauch zugewiesen ist. Für die Anzahl Leiterplatten und den Spurverbrauch kann jeweils eine Schwelle angegeben werden, unterhalb derer der jeweilige Wert als "gering" anerkannt wird. Einrichtungen, die an einer Bestückungslinie zur Vorratshaltung unterschiedlicher Bauteile vorgesehen sind, umfassen dabei eine vorbestimmte Anzahl Spuren, die üblicherweise jeweils 8mm breit sind. Dadurch kann eine Neuzuordnung von Leiterplatten der betreffenden Rüstfamilie zu einer anderen Bestückungslinie erzwungen werden.

Analog dazu kann auch eine Zuordnung einer Leiterplatte an eine Bestückungslinie fixiert werden, indem eine Änderung einer bereits erfolgten Zuordnung verhindert wird, falls der korrespondierenden Rüstfamilie eine hohe Anzahl von Leiterplatten oder ein hoher Spurverbrauch zugewiesen ist. Auch hier können Schwellenwerte angegeben werden, oberhalb derer der jeweilige Wert als "hoch" anerkannt wird. Die Optimierung der Zuordnung von Leiterplatten an Bestückungslinien kann dadurch beschleunigt bzw. verbessert werden.

Ein Computerprogrammprodukt umfasst Programmcodemittel zur Durchführung des beschriebenen Verfahrens, wenn es auf einer Ausführungseinrichtung abläuft. Das Computerprogrammprodukt kann in einer üblichen Programmiersprache

(z.B. C++, Java) erstellt sein. Die Verarbeitungseinrichtung kann einen marktüblichen Computer oder Server mit entsprechenden Eingabe-, Ausgabe- und Speichermitteln umfassen.

Eine Steuereinrichtung zur Zuordnung von Leiterplatten an Bestückungslinien eines Bestückungssystems ist zur Durchführung des oben beschriebenen Verfahrens eingerichtet.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:

Fig. 1    ein Bestückungssystem;

Fig. 2     eine Veranschaulichung von Rüstfamilien am Bestückungssystem von Fig. 1; und

Fig. 3     ein Ablaufdiagramm eines Optimierungsverfahrens mittels ganzzahliger linearer Programmierung

darstellt.

Die Lineare Optimierung ist eines der Hauptverfahren auf dem Gebiet mathematische Optimierung und befasst sich mit der Optimierung linearer Zielfunktionen über einer Menge, die durch lineare Gleichungen und Ungleichungen eingeschränkt ist. Die Lineare Optimierung ist die Grundlage der Lösungsverfahren der (gemischt) ganzzahligen linearen Optimierung.

Vorteile der linearen Optimierung:

- Globaler Optimierungsansatz.
- Leicht erweiterbar.
- Sehr gute kommerzielle Standard-Solver (SCIP, CPLEX, Ilog, Xpress), die in der Praxis weit verbreitet und bewährt sind.
- Für eine ermittelte Lösung ist bekannt, wie weit sie maximal von der optimalen Lösung entfernt ist (Gap).

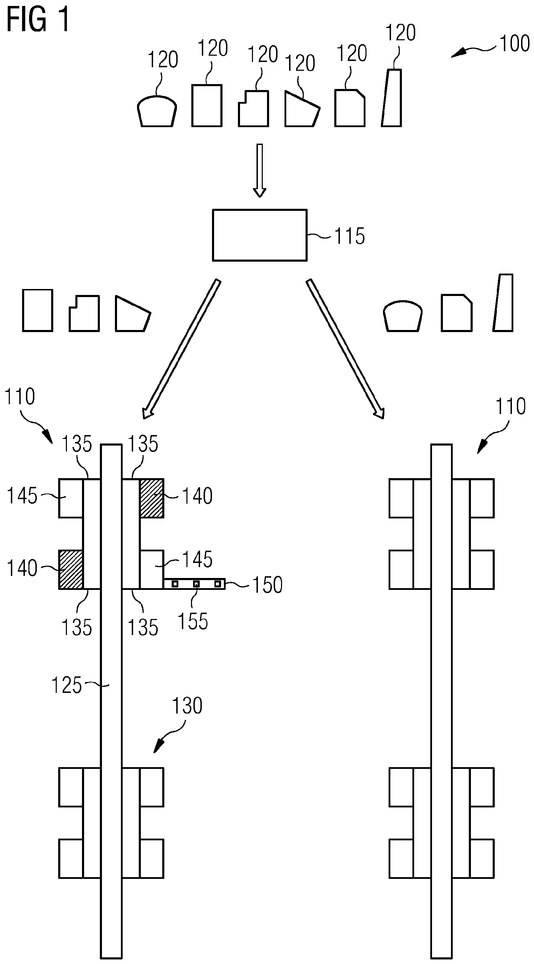

Figur 1 zeigt ein Bestückungssystem 100. Das Bestückungssystem 100 umfasst mehrere Bestückungslinien 110 und eine Steuereinrichtung 115 zur Zuordnung von Leiterplatten 120 an die Bestückungslinien 110. Jede Bestückungslinie 110 umfasst üblicherweise ein Transportsystem 125 und ein oder mehrere Bestückungsautomaten 130. Jeder Bestückungsautomat 130 umfasst einen oder mehrere Bestückungsköpfe 135, die jeweils dazu eingerichtet sind, von einem konstanten Tisch 140 oder einem variablen Tisch 145 Bauelemente aufzunehmen und an einer vorbestimmten Position auf der Leiterplatte 120 zu positionieren, die sich auf dem Transportsystem 125 befindet.

Während des Bestückungsvorgangs besteht die Leiterplatte 120 bezüglich des Bestückungsautomaten 130 üblicherweise still. Die Tische 140, 145 umfassen jeweils eine Vielzahl Zuführungseinrichtungen 150, von denen nur eine exemplarisch dargestellt ist. Jede Zuführungseinrichtung 150 hält einen Vorrat von Bauteilen 155 eines vorbestimmten Typs bereit. Zwar kann jede Zuführungseinrichtung 150 zur Bereithaltung unterschiedlicher Bauteile 155 konfiguriert werden und unterschiedliche Zuführungseinrichtungen 150 an einem Tisch 140, 145 angebracht werden, jedoch werden die Tische 140, 145 aus Geschwindigkeitsgründen üblicherweise komplett ausgetauscht, wenn ein Bestückungsautomat 130 mit Bauteilen 155 versorgt werden muss, die nicht auf einem der angebrachten Tische 140, 145 vorgehalten sind.

Da ein solcher Wechsel üblicherweise mit einem Produktionsstillstand verbunden ist, wird angestrebt, die Zahl der zu wechselnden Tische 140, 145 gering zu halten. Wird ein Tisch während eines Umrüstvorgangs nicht ausgetauscht, so wird er als konstanter Tisch 140 bezeichnet, ansonsten als variabler Tisch 145. Funktionale Unterschiede zwischen einem konstanten Tisch 140 und einem variablen Tisch 145 bestehen ansonsten nicht.

Die Leiterplatte 120 ist mit einer Anzahl unterschiedlicher Bauteile 155 zu bestücken. Um ein häufiges Wechseln von variablen Tischen 145 zu minimieren und idealerweise eine Zahl konstanter Tische 140 zu maximieren, ist die Steuereinrichtung 115 dazu eingerichtet, die Zuordnung einer Leiterplatte 120 an eine der Bestückungslinien 110 zu optimieren. Dabei müssen üblicherweise spezifische Eigenschaften jeder Bestückungslinie 110 bzw. jedes Bestückungsautomaten 130 genauso berücksichtigt werden, wie Eigenschaften der Leiterplatten 120 bzw. der auf ihnen zu bestückenden Bauteile 155.

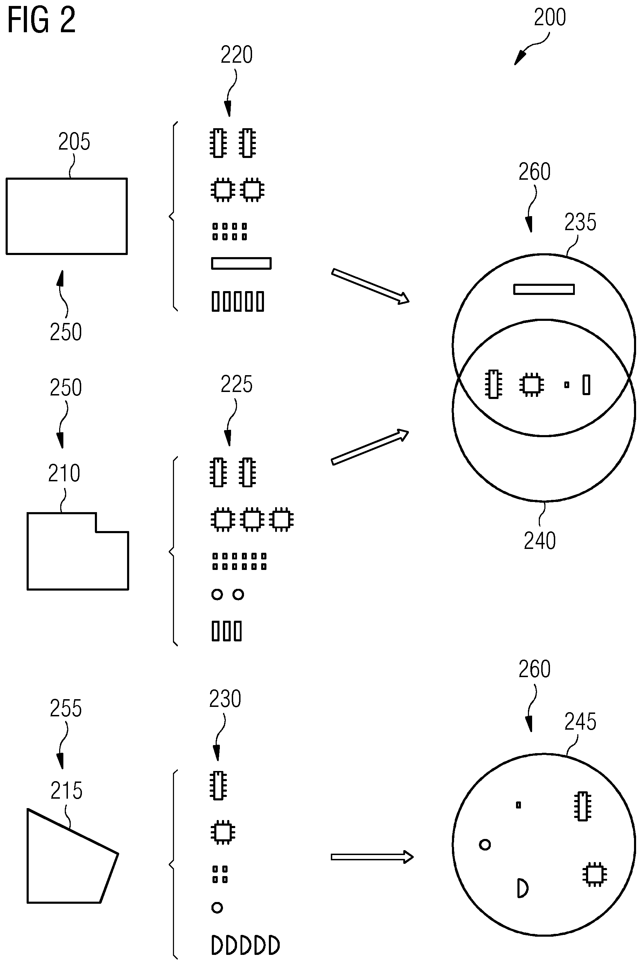

Figur 2 zeigt eine Veranschaulichung 200 von Rüstfamilien, die auch "Cluster" genannt werden. Betrachtet werden eine erste Leiterplatte 205, eine zweite Leiterplatte 210 und eine dritte Leiterplatte 215, die jeweils einer der Leiterplatten 120 im Bestückungssystem 100 aus Figur 1 entsprechen. Der ersten Leiterplatte 205 ist eine erste Menge 220 von Bauteilen 155, der zweiten Leiterplatte 210 eine zweite Menge 225 von Bauteilen 155 und der dritten Leiterplatte 215 eine dritte Menge 230 von Bauteilen 155 zugeordnet. In exemplarischer Weise umfassen die Mengen 220 bis 230 jeweils fünf unterschiedliche Bauteiltypen, von denen Bauteile 155 in unterschiedlichen Anzahlen verwendet werden. Bauteile 155 eines Bauteiltyps sind im Rahmen des betrachteten Verfahrens 200 nicht voneinander unterscheidbar. Den Mengen 220 bis 230 von Bauteilen 155 sind daher Mengen 235 bis 245 von Bauteiltypen zugeordnet. In den Mengen 235 bis 245 findet sich jedes der Bauteile 155 der zugeordneten Menge 220 bis 230 nur einmal wieder.

Eine Rüstfamilie umfasst diejenigen Leiterplatten 120, die zur Bestückung auf einer Bestückungslinie 100 zugeordnet sind. Im Beispiel von Figur 2 sind die Leiterplatten 205 und 210 der gleichen Bestückungslinie 110 zugeordnet und bilden eine erste Rüstfamilie 250. Die erste Rüstfamilie 250 erfordert daher eine erste Rüstung 260 mit Bauteiltypen der Vereinigungsmenge der Mengen 235 und 240, die den Leiterplatten 205 bzw. 210 zugeordnet sind. Im dargestellten Beispiel umfasst die erste Rüstung 260 sechs Bauteiltypen. Unter Bereitstellung der Bauteiltypen der ersten Rüstung 260 lassen sich die Leiterplatten 205 und 210 der ersten Rüstfamilie 250 ohne Umrüstung auf der Bestückungslinie 110 bestücken.

Die dritte Leiterplatte 215 ist einer anderen Bestückungslinie 110 zugeordnet und bildet allein eine zweite Rüstfamilie 255. Eine der zweiten Rüstfamilie 255 zugeordnete zweite Rüstung 265 umfasst fünf Bauteiltypen.

Umfassen die Mengen 220 und 225 viele Bauteile 155 des gleichen Bauteiltyps, so umfasst die erste Rüstung 260 auch nur eine geringe Anzahl unterschiedlicher Bauteiltypen. Üblicherweise wird versucht, die Leiterplatten 120 derart an Rüstfamilien 250, 255 zuzuweisen, dass möglichst viele unterschiedliche Leiterplatten 120 mit der Bestückungslinie 110 verarbeitet werden können.

Die dritte Leiterplatte 215 ist einer anderen Bestückungslinie 110 zugeordnet und bildet allein eine zweite Rüstfamilie 255. Eine der zweiten Rüstfamilie 255 zugeordnete zweite Rüstung 265 umfasst fünf Bauteiltypen.

Würde die dritte Leiterplatte 215 der gleichen Rüstfamilie wie die Leiterplatte 205 und 210 zugeordnet, so enthielte die der resultierenden Rüstfamilie zugeordnete Rüstung die Bauelementtypen der Vereinigungsmenge der Mengen 235 bis 245, im vorliegenden Beispiel also sieben Bauelementtypen. Weist die Bestückungslinie 110 beispielsweise nur Aufnahmekapazitäten für sechs unterschiedliche Bauteile 155 auf, so kann die solchermaßen gebildete Rüstfamilie der Bestückungslinie 110 nicht zugeordnet werden bzw. die dritte Leiterplatte 215 passt nicht mehr in die der Bestückungslinie 110 zugeordnete Rüstfamilie.

Ein Rüstwechsel ist erforderlich, um Leiterplatten 120 einer anderen Rüstfamilie auf der Bestückungslinie 110 zu bestücken. Dabei werden üblicherweise eines oder mehrere Zuführungselemente, insbesondere ein variabler Tisch 145 oder ein Förderer 150 an einem Bestückungsautomaten 130 der Bestückungslinie 110 gewechselt.

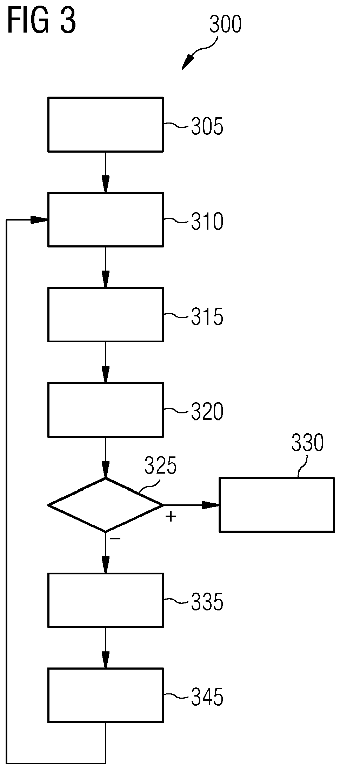

Die Zahl der Rüstwechsel kann verkleinert und eine Anzahl konstanter Tische 140 vergrößert werden, indem die Anzahl von Rüstfamilien 250, 255 der Bestückungslinie 110 verkleinert wird. Dies kann durch eine geschickte Zuordnung der Leiterplatten 120 an die Rüstfamilien 250, 255 erzielt werden. Die Optimierung der Zuordnung von Leiterplatten 120 an die Rüstfamilien 250, 255 soll daher im Folgenden mit Bezug auf Figur 3 genauer erläutert werden.

Ein Verfahren 300 zur Zuordnung von Leiterplatten 120 zu Bestückungslinien 110 ist in Form eines Ablaufdiagramms in Figur 3 dargestellt.

Schritt 305: Zunächst wird eine Startzuordnung von Leiterplatten 120 auf Bestückungslinien 110 bestimmt und eine aktuelle Zuordnung wird der Startzuordnung gleichgesetzt. Für die Ermittlung der Startzuordnung sind unterschiedliche Heuristiken möglich, die auch manuelle Vorgaben oder Restriktionen umfassen können.

Schritt 310: Anschließend wird eine Teilmenge von Leiterplatten 120 aus den zuzuordnenden Leiterplatten 120 ausgewählt. Diese Auswahl erfolgt üblicherweise so, dass bei aufeinander folgenden Durchläufen des Verfahrens 300 unterschiedliche Teilmengen ausgewählt werden.

Schritt 315: Danach werden eine oder mehrere alternative Zuordnungen von Leiterplatten 120 der Teilmenge an die Bestückungslinien 110 gebildet, vorzugsweise mittels ganzzahliger linearer Programmierung. Diese Zuordnungen erfolgen mit Bezug auf Figur 2 derart, dass die Summe der Anzahlen der Rüstfamilien 250, 255 über alle Bestückungslinien 110 minimiert ist. Es kann auch ein gewichtetes Kriterium mehrerer Einzelkriterien für die Zuordnung verwendet werden, so dass auch noch weitere Parameter möglichst minimiert oder möglichst maximiert werden können, um eine optimierte Zuordnung zu erzielen.

Schritt 320: Hier wird die Qualität der bestimmten Zuordnungen bestimmt, indem ein einzelnes oder zusammengesetztes Kriterium gebildet wird. Das Kriterium wird auf der Basis einer Anzahl Rüstfamilien für die Bestückungslinien 110 gebildet. In einer bevorzugten Ausführungsform wird hierfür ein von der ganzzahligen linearen Programmierung separates Verfahren aufgerufen, welches auf der Basis der bestimmten Zuordnung zunächst die Rüstfamilien für die Bestückungslinien bildet und anschließend die Summe der bestimmten Rüstfamilien über alle Bestückungslinien 110 bildet.

In noch einer weiteren Ausführungsform kann das Kriterium die Einhaltung einer vorbestimmten Bedingung umfassen. Beispielsweise kann die Bedingung beinhalten, dass die Anzahl Rüstfamilien jeder Bestückungslinie 110 größer oder kleiner als eine vorbestimmte Schwelle ist, wobei die Schwelle jeweils individuell einer Bestückungslinie 110 zugeordnet sein kann. Ist die Bedingung erfüllt, so kann das Kriterium auf einen ersten vorbestimmten Wert gesetzt werden, andernfalls auf einen zweiten. So kann verhindert werden, dass eine Zuordnung akzeptiert wird, wenn die Bedingung nicht erfüllt ist.

In weiteren Ausführungsformen kann als Bedingung auch gefordert sein, dass Unterschiede zwischen den Anzahlen von Rüstfamilien jeder Bestückungslinie 110 unter einer vorbestimmten Schwelle liegen. Diese Schwelle kann insbesondere Null betragen. In einer Variante können die Unterschiede auch quantifiziert als Kriterium ausgedrückt werden, so dass das Verfahren 300 Optimierung bezüglich des Kriteriums durchführen kann.

In weiteren Ausführungsformen kann das Kriterium aus mehreren Einzelkriterien zusammengesetzt sein, die unter Verwendung von Gewichtungsfaktoren zu einem gesamten Kriterium zusammen addiert oder miteinander multipliziert werden können. Beispielsweise können Einzelkriterien eines oder mehrere der oben genannten Kriterien, einen Auslastungsgrad eines Bestückungsautomaten 130, das Verhältnis von konstanten Tischen 140 zu variablen Tischen 145 oder einen Auslastungsgrad eines Bestückungsautomaten 130 betreffen.

Schritt 325: Danach wird überprüft, ob ein vorbestimmtes Abbruchkriterium erreicht ist. Das Abbruchkriterium ist erfüllt, falls das Kriterium bzw. Gesamtkriterium von Schritt 320 einen vorbestimmten Schwellenwert erreicht hat. Die Zuordnung kann auch abgebrochen werden, wenn eine vorbestimmte Bestimmungszeit für das Verfahren 300 abgelaufen ist. Dadurch kann eine endlose Optimierung der Zuordnung verhindert werden.

Schritt 330: Die bestimmten Zuordnungen werden ausgegeben, falls das Abbruchkriterium erfüllt ist.

Schritt 335: Andernfalls können unter den bestimmten Zuordnungen solche ausgewählt werden, die weiter optimiert werden sollen. Beispielsweise kann die zuletzt bestimmte Zuordnung zugunsten einer bei einem vorherigen Durchlauf bestimmten Zuordnung fallen gelassen werden, falls die ältere Zuordnung ein besseres Kriterium bzw. Gesamtkriterium aufweist.

Schritt 340: In diesem Fall wird die aktuelle Zuordnung auf eine der zu optimierenden Zuordnungen gesetzt und das Verfahren 300 kann ab dem Schritt 310 erneut durchlaufen. Wurden mehrere optimierbare Zuordnungen ausgewählt, so kann das Verfahren 300 auch entsprechend mehrfach parallel verzweigt werden.

Mathematischer Hintergrund

Durch den Einsatz von exakten mathematischen Verfahren lassen sich deutlich bessere Lösungen erzielen als mit bisher in der Praxis verwendeten Heuristiken. Im weiteren Unterschied dazu können mit diesen Verfahren auch gute Produktionszeiten erreicht werden.

Bei der Zuordnung von Leiterplatten 120 bzw. Baugruppen an eine Bestückungslinie 110 ist zu beachten, dass auf Grund von technischen Restriktionen kann nicht jede Leiterplatte 120 auf jeder Bestückungslinie 110 gefertigt werden. Die Leiterplatten besitzen auf den Bestückungslinien 110 meist auch unterschiedliche Produktionszeiten. Zudem dürfen die maximalen Produktionszeitkapazitäten der Bestückungslinien 110 nicht überschritten werden.

Bei der Zuordnung von Leiterplatten 120 auf Bestückungslinien 110 werden üblicherweise folgende Ziele verfolgt:

- es sollen möglichst viele Leiterplatten 120 mit konstanten Tischen 140 gefertigt werden können, um den Umrüstaufwand zu reduzieren
- die Anzahl der Rüstfamilien ("Cluster") an den Bestückungslinien 110 soll möglichst gering sein, um den zeitlichen Umrüstaufwand zu reduzieren
- man möchte möglichst wenig Rüstequipment (z.B. Förderer 150) benötigen
- die Gesamtproduktionszeit für die Leiterplatten 120 sollte möglichst minimal sein.

Diese Ziele versucht man gewöhnlich zu erreichen, indem eine möglichst hohe Bauteilüberdeckung der Leiterplatten 120 einer Bestückungslinie 110 angestrebt wird, bzw. die Summe der Bauelementvarianzen der Bestückungslinien 110 minimiert wird.

Zur Bestimmung einer optimierten Zuordnung von Leiterplatten 120 an Bestückungslinien 110 werden IP-Modelle (IP steht für Integer Programmierung bzw. für Integer Programm oder ganzzahliges Optimierungsmodell) verwendet. Diese Bestimmung kann mittels eines bekannten Standard-Solvers durchgeführt werden.

**Indices**

L  Menge der SMT-Bestücklinien 110 des Systems 100
R  Menge der Leiterplatten 120
C  Menge der Bauelementtypen 155
$R_c$  Menge der Leiterplatten mit Bauelementtyp c
$R_l$  Menge der bestückbaren Leiterplatten auf Linie $l$

**Parameter**

$Time_{r,l}$  Gesamtproduktionszeit für Leiterplatte r auf Linie $l$
$TimeLimit_l$  Produktionszeitschranke auf Linie $l$

**Binär-Variablen**

$Assign_{r,l}$  Zuordnung Leiterplatte r zu Linie $l$

$Setup_{c,l}$     Verwendung eines Bauelements c auf einer Linie *l*

**IP Formulierung**

$$\text{minimize} \sum_{c \in C} \sum_{l \in L} Setup_{c,l}$$

s.t. :

$$\sum_{l \in L} Assign_{r,l} = 1 \qquad\qquad r \in R$$

$$Assign_{r,l} = 0 \qquad\qquad l \in L, r \in R / R_l$$

$$\sum_{r \in R_c} Assign_{r,l} \leq Setup_{c,l} |R_c| \qquad\qquad c \in C, l \in L$$

$$\sum_{r \in R} Assign_{r,l} Time_{r,l} \leq TimeLimit_l \qquad\qquad l \in L$$

$$Setup_{c,l} \in \{0,1\} \qquad\qquad c \in C, l \in L$$

$$Assign_{r,l} \in \{0,1\} \qquad\qquad r \in R, l \in L$$

Zur Verbesserung der Zuordnung von Leiterplatten 120 an Bestückungslinien 110 können dem Solver Bedingungen zur Verfügung gestellt werden. Die gestellten Bedingungen zielen darauf ab, eine Optimierung der Zuordnung von Leiterplatten 120 auf die Bestückungslinien 110 derart durchzuführen, dass die Summe der Anzahlen Rüstfamilien aller Bestückungslinien 110 des Bestückungssystems 100 minimiert ist.

Durch Anwendung dieser Vorgabe kann eine verbesserte Verteilung der Leiterplatten 120 über die Bestückungslinen 110 bewirkt werden, wobei ausgeglichene Größen von Rüstfamilien bewirkt werden können. Das Bestückungssystem 100 kann so mit verbesserter Effizienz bzw. Auslastung betrieben werden. Außerdem können die Zuordnungen mit dem beschriebenen Ansatz mittels eines IP-Solvers rascher als bislang bekannt bestimmbar sein.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1.  Verfahren (200) zum Bestücken von Leiterplatten (120) auf Bestückungslinien (110) eines Bestückungssystems (100) zur Bestückung der Leiterplatten (120) mit elektronischen Bauteilen (155), wobei das Verfahren (200) folgende Schritte umfasst:

    - Erfassen (205) von Anforderungen zur Bestückung mehrerer Leiterplatten (120) mit jeweils zugeordneten Bauteilen (155) ;
    - Bestimmen einer Startzuordnung von Leiterplatten (120) auf Bestückungslinien (110);

- Auswählen einer Teilmenge von Leiterplatten (120) aus den zuzuordnenden Leiterplatten (120), wobei bei aufeinander folgenden Durchläufen des Verfahrens (200) unterschiedliche Teilmengen ausgewählt werden;
- Zuordnen (315) der Leiterplatten (120) der Teilmenge zu den Bestückungslinien (110) mittels ganzzahliger linearer Programmierung derart, dass die Summe der Bauteilevarianzen der Bestückungslinien (110) minimiert ist,
- wobei die Bauelementevarianz einer Bestückungslinie (110) durch die Anzahl unterschiedlicher Bauteile (155) gegeben ist, die auf die Leiterplatten (120) zu bestücken sind, die der Bestückungslinie (110) zugeordnet sind;
- wobei das Zuordnen (315) unter bestimmten Vorgaben erfolgt, die umfassen, dass

    - auf Grund von technischen Restriktionen nicht jede Leiterplatte (120) auf jeder Bestückungslinie (110) gefertigt werden kann,
    - die Leiterplatten auf den Bestückungslinien (110) meist unterschiedliche Produktionszeiten besitzen und
    - maximale Produktionszeitkapazitäten der Bestückungslinien (110) nicht überschritten werden dürfen;

- Bestimmen (325) von Rüstfamilien für die Bestückungslinien auf der Basis der Zuordnung,
- wobei eine Rüstfamilie bestimmt ist als eine Menge von Leiterplatten (120), die auf einer Bestückungslinie (110) bestückt werden können, ohne die Menge der Bauteiltypen zu ändern, die an der Bestückungslinie (110) für die Bestückung bereit gehalten sind, und
- erneutes Zuordnen (315), bis ein Kriterium eine vorbestimmte Schwelle erreicht hat,
- wobei das Kriterium auf der Basis der Anzahlen Rüstfamilien der Bestückungslinien (110) gebildet ist
- und das Kriterium wenigstens eine der folgenden Bedingungen umfasst:

    - dass die Anzahl Rüstfamilien jeder Bestückungslinie (110) größer als eine erste vorbestimmte Schwelle ist;
    - dass die Anzahl Rüstfamilien jeder Bestückungslinie (110) kleiner als eine zweite vorbestimmte Schwelle ist und
    - dass Unterschiede zwischen den Anzahlen von Rüstfamilien jeder Bestückungslinie (110) unter einer vorbestimmten Schwelle liegen, und

- Bestücken der Leiterplatten (120) auf den jeweils zugeordneten Bestückungslinien (110).

2. Verfahren (200) nach Anspruch 1, wobei eine der vorbestimmten Schwellen für wenigstens eine der Bestückungslinien (110) individuell vorbestimmbar ist.

3. Verfahren (200) nach einem der vorangehenden Ansprüche, wobei das Zuordnen von Leiterplatten (120) einer Rüstfamilie zu einer Bestückungslinie (110) verhindert wird, falls der Rüstfamilie eine Anzahl Leiterplatten (120) zugewiesen ist, die unter einer ersten angegebenen Schwelle liegt, oder ein Spurverbrauch zugewiesen ist, der unter einer zweiten angegebenen Schwelle liegt, wobei der Spurverbrauch angibt, welche vorbestimmte Anzahl Spuren fester Breite durch Einrichtungen, die an einer Bestückungslinie zur Vorratshaltung unterschiedlicher Bauteile vorgesehen sind, verbrauchen.

4. Verfahren (200) nach einem der vorangehenden Ansprüche, wobei ein Ändern einer Zuordnung von Leiterplatten (120) einer Rüstfamilie zu einer Bestückungslinie (110) verhindert wird, falls der Rüstfamilie eine Anzahl Leiterplatten (120) zugewiesen ist, die über einer ersten angegebenen Schwelle liegt, oder ein Spurverbrauch zugewiesen ist, der über einer zweiten angegebenen Schwelle liegt, wobei der Spurverbrauch angibt, welche vorbestimmte Anzahl Spuren fester Breite durch Einrichtungen, die an einer Bestückungslinie zur Vorratshaltung unterschiedlicher Bauteile vorgesehen sind, verbrauchen.

5. Computerprogrammprodukt mit Programmcodemitteln zur Durchführung des Verfahrens (200) nach einem der vorangehenden Ansprüche, wenn das Computerprogrammprodukt auf einer Ausführungseinrichtung (115) abläuft.

6. Steuereinrichtung (115) zur Steuerung der Bestückung von Leiterplatten (120) mittels Bestückungslinien (110) eines Bestückungssystems, wobei die Steuereinrichtung (115) dazu eingerichtet ist,

    - Anforderungen zur Bestückung mehrerer Leiterplatten (120) mit jeweils zugeordneten Bauteilen (155) zu erfassen und die Leiterplatten (120) unter gegebenen Vorgaben mittels ganzzahliger linearer Programmierung an Bestückungslinien (110) zuzuordnen (315),
    - wobei die bestimmten Vorgaben umfassen, dass auf Grund von technischen Restriktionen nicht jede Leiterplatte (120) auf jeder Bestückungslinie (110) gefertigt werden kann, dass die Leiterplatten auf den Bestückungslinien (110) meist unterschiedliche Produktionszeiten besitzen und dass maximale Produktionszeitkapazitäten der Bestückungslinien (110) nicht überschritten werden dürfen,
- wobei das Zuordnen (315) folgendes umfasst:

◦ Bestimmen einer Startzuordnung von Leiterplatten (120) auf Bestückungslinien (110),
◦ Auswählen einer Teilmenge von Leiterplatten (120) aus den zuzuordnenden Leiterplatten (120),
◦ wobei bei aufeinander folgenden Durchläufen des Verfahrens (200) unterschiedliche Teilmengen ausgewählt werden;
◦ Zuordnen (315) der Leiterplatten (120) der Teilmenge zu den Bestückungslinien (110) mittels ganzzahliger linearer Programmierung derart, dass die Summe der Bauteilevarianzen der Bestückungslinien (110) minimiert ist,
◦ wobei die Bauelementevarianz einer Bestückungslinie (110) durch die Anzahl unterschiedlicher Bauteile (155) gegeben ist, die auf die Leiterplatten (120) zu bestücken sind, die der Bestückungslinie (110) zugeordnet sind;

- wobei die Steuereinrichtung (115) weiter dazu eingerichtet ist, Rüstfamilien für die Bestückungslinien (110) auf der Basis der Zuordnung zu bestimmen, wobei eine Rüstfamilie bestimmt ist als eine Menge von Leiterplatten (120), die auf einer Bestückungslinie (110) bestückt werden können, ohne die Menge der Bauteiltypen zu ändern, die an der Bestückungslinie (110) für die Bestückung bereit gehalten sind,
- und eine erneute Zuordnung (325) durchzuführen, bis ein Kriterium eine vorbestimmte Schwelle erreicht hat, wobei das Kriterium auf der Basis der Anzahlen Rüstfamilien der Bestückungslinien (110) gebildet ist,
- wobei das Kriterium wenigstens eine der folgenden Bedingungen umfasst:

- dass die Anzahl Rüstfamilien jeder Bestückungslinie (110) größer als eine erste vorbestimmte Schwelle ist,
- dass die Anzahl Rüstfamilien jeder Bestückungslinie (110) kleiner als eine zweite vorbestimmte Schwelle ist und
- dass Unterschiede zwischen den Anzahlen von Rüstfamilien jeder Bestückungslinie (110) unter einer vorbestimmten Schwelle liegen, und

- Bestücken der Leiterplatten (120) auf den jeweils zugeordneten Bestückungslinien (110).

## Claims

1. Method (200) for fitting printed circuit boards (120) with components on fitting lines (110) of a fitting system (100) for fitting the printed circuit boards (120) with electronic components (155), the method (200) comprising the following steps:

- detecting (205) requirements for fitting a plurality of printed circuit boards (120) with respectively allocated components (155);
- determining a starting allocation of printed circuit boards (120) on fitting lines (110);
- selecting a subset of printed circuit boards (120) from the printed circuit boards (120) to be allocated, different subsets being selected during successive runs of the method (200);
- allocating (315) the printed circuit boards (120) in the subset to the fitting lines (110) by means of integer linear programming in such a manner that the sum of component variances of the fitting lines (110) is minimized,
- the component variance of a fitting line (110) being given by the number of different components (155) to be fitted to the printed circuit boards (120) allocated to the fitting line (110);
- the allocation (315) being carried out under particular specifications which comprise the fact that

- not every printed circuit board (120) on each fitting line (110) can be manufactured on account of technical restrictions,
- the printed circuit boards on the fitting lines (110) usually have different production times, and
- maximum production time capacities of the fitting lines (110) must not be exceeded;

- determining (325) equipment families for the fitting lines on the basis of the allocation,
- an equipment family being determined as a set of printed circuit boards (120) which can be fitted with components on a fitting line (110) without changing the quantity of component types which are kept available on the fitting line (110) for the fitting process, and

EP 2 829 165 B1

- reallocating (315) until a criterion has reached a predetermined threshold,
- the criterion being formed on the basis of the numbers of equipment families of the fitting lines (110),
- and the criterion comprising at least one of the following conditions:

> - the number of equipment families of each fitting line (110) is greater than a first predetermined threshold;
> - the number of equipment families of each fitting line (110) is less than a second predetermined threshold, and
> - differences between the numbers of equipment families of each fitting line (110) are below a predetermined threshold, and

> - fitting the printed circuit boards (120) with components on the respectively allocated fitting lines (110).

2. Method (200) according to Claim 1, one of the predetermined thresholds being able to be individually predetermined for at least one of the fitting lines (110).

3. Method (200) according to one of the preceding claims, the allocation of printed circuit boards (120) in an equipment family to a fitting line (110) being prevented if the equipment family is assigned a number of printed circuit boards (120) which is below a first stated threshold or is assigned a track consumption which is below a second stated threshold, the track consumption indicating what predetermined number of tracks of a fixed width are consumed by devices which are provided on a fitting line for stockpiling different components.

4. Method (200) according to one of the preceding claims, a change of an allocation of printed circuit boards (120) in an equipment family to a fitting line (110) being prevented if the equipment family is assigned a number of printed circuit boards (120) which is above a first stated threshold or is assigned a track consumption which is above a second stated threshold, the track consumption indicating what predetermined number of tracks of a fixed width are consumed by devices which are provided on a fitting line for stockpiling different components.

5. Computer program product having program code means for carrying out the method (200) according to one of the preceding claims when the computer program product runs on an execution device (115).

6. Control device (115) for controlling the fitting of printed circuit boards (120) with components using fitting lines (110) of a fitting system, the control device (115) being set up

> - to detect requirements for fitting a plurality of printed circuit boards (120) with respectively allocated components (155) and to allocate (315) the printed circuit boards (120) to fitting lines (110) under given specifications by means of integer linear programming,
> - the particular specifications comprising the fact that not every printed circuit board (120) on each fitting line (110) can be manufactured on account of technical restrictions, the printed circuit boards on the fitting lines (110) usually have different production times, and maximum production time capacities of the fitting lines (110) must not be exceeded,
> - the allocation (315) comprising the following:

>> o determining a starting allocation of printed circuit boards (120) on fitting lines (110),
>> o selecting a subset of printed circuit boards (120) from the printed circuit boards (120) to be allocated,
>> o different subsets being selected during successive runs of the method (200);
>> o allocating (315) the printed circuit boards (120) in the subset to the fitting lines (110) by means of integer linear programming in such a manner that the sum of component variances of the fitting lines (110) is minimized,
>> o the component variance of a fitting line (110) being given by the number of different components (155) to be fitted to the printed circuit boards (120) allocated to the fitting line (110);

> - the control device (115) also being set up to determine equipment families for the fitting lines (110) on the basis of the allocation, an equipment family being determined as a set of printed circuit boards (120) which can be fitted with components on a fitting line (110) without changing the quantity of component types which are kept available on the fitting line (110) for the fitting process,
> - and to carry out a reallocation (325) until a criterion has reached a predetermined threshold, the criterion being formed on the basis of the numbers of equipment families of the fitting lines (110),
> - the criterion comprising at least one of the following conditions:

- the number of equipment families of each fitting line (110) is greater than a first predetermined threshold,
- the number of equipment families of each fitting line (110) is less than a second predetermined threshold, and
- differences between the numbers of equipment families of each fitting line (110) are below a predetermined threshold, and

- fitting the printed circuit boards (120) with components on the respectively allocated fitting lines (110).

**Revendications**

1. Procédé (200) d'équipement de cartes de circuits imprimés (120) sur des lignes de montage (110) d'un système de montage (100) destiné au montage de composants électroniques (155) sur les cartes de circuits imprimés (120), le procédé (200) comprenant les étapes suivantes :

   - identification (205) d'exigences relatives au montage de composants (155) respectivement affectés sur plusieurs cartes de circuits imprimés (120) ;
   - détermination d'une affectation de départ de cartes de circuits imprimés (120) sur des lignes de montage (110) ;
   - sélection d'un sous-ensemble de cartes de circuits imprimés (120) parmi les cartes de circuits imprimés (120) à affecter, des sous-ensembles différents étant sélectionnés lors de cycles successifs du procédé (200) ;
   - affectation (315) des cartes de circuits imprimés (120) du sous-ensemble aux lignes de montage (110) grâce à une programmation linéaire en nombres entiers, de façon que la somme des variances des composants des lignes de montage (110) soit minimisée,
   - dans lequel la variance des composants d'une ligne de montage (110) est définie par le nombre de composants (155) différents qui doivent être montés sur les cartes de circuits imprimés (120) qui sont affectées à la ligne de montage (110) ;
   - dans lequel l'affectation (315) est effectuée selon des consignes définies qui stipulent

      - qu'en raison de restrictions techniques, les cartes de circuits imprimés (120) ne peuvent pas toutes être montées sur chaque ligne de montage (110),
      - que des temps de production différents sont la plupart du temps alloués aux cartes de circuits imprimés sur les lignes de montage (110), et
      - que les capacités maximales en matière de temps de production des lignes de montage (110) ne doivent pas être dépassées ;

   - détermination (325) de familles d'équipement pour les lignes de montage sur la base de l'affectation,
   - dans lequel une famille d'équipement est définie comme une quantité de cartes de circuits imprimés (120) qui peuvent être montées sur une ligne de montage (110) sans changer la quantité des types de composants qui sont tenus à disposition pour le montage au niveau de la ligne de montage (110), et
   - nouvelle affectation (315) jusqu'à ce qu'un critère ait atteint un seuil prédéfini,
   - dans lequel le critère est formé sur la base des nombres de familles d'équipement des lignes de montage (110), et
   - le critère comprend au moins une des conditions suivantes :

      - que le nombre de familles d'équipement de chaque ligne de montage (110) soit supérieur à un premier seuil prédéfini ;
      - que le nombre de familles d'équipement de chaque ligne de montage (110) soit inférieur à un second seuil prédéfini, et
      - que les différences entre les nombres de familles d'équipement de chaque ligne de montage (110) se situent en-dessous d'un seuil prédéfini, et

   - équipement des cartes de circuits imprimés (120) sur les lignes de montage (110) respectivement affectées.

2. Procédé (200) selon la revendication 1, dans lequel un des seuils prédéfinis pour au moins une des lignes de montage (110) peut être prédéfini de manière individuelle.

3. Procédé (200) selon l'une des revendications précédentes, dans lequel l'affectation de cartes de circuits imprimés (120) d'une famille d'équipement à une ligne de montage (110) est empêchée dans le cas où un nombre de cartes de circuits imprimés (120) se situant en-dessous d'un premier seuil indiqué est alloué à la famille d'équipement, ou dans le cas où une utilisation de voies se situant en-dessous d'un second seuil indiqué est allouée, l'utilisation de voies indiquant le nombre prédéfini de voies de largeur fixe qui est utilisé par des dispositifs qui sont prévus pour le stockage de différents composants au niveau d'une ligne de montage.

4. Procédé (200) selon l'une des revendications précédentes, dans lequel un changement d'une affectation de cartes de circuits imprimés (120) d'une famille d'équipement à une ligne de montage (110) est empêché dans le cas où un nombre de cartes de circuits imprimés (120) se situant au-dessus d'un premier seuil indiqué est alloué à la famille d'équipement, ou dans le cas où une utilisation de voies se situant au-dessus d'un second seuil indiqué est allouée, l'utilisation de voies indiquant le nombre prédéfini de voies de largeur fixe qui est utilisé par des dispositifs qui sont prévus pour le stockage de différents composants au niveau d'une ligne de montage.

5. Produit programme d'ordinateur avec moyens de code de programme pour l'exécution du procédé (200) selon l'une des revendications précédentes lorsque le produit programme d'ordinateur se déroule sur un dispositif d'exécution (115).

6. Dispositif de commande (115) destiné à commander l'équipement de cartes de circuits imprimés (120) au moyen de lignes de montage (110) d'un système de montage, le dispositif de commande (115) étant conçu pour

- identifier des exigences relatives au montage de composants (155) respectivement affectés sur plusieurs cartes de circuits imprimés (120) et affecter (315) les cartes de circuits imprimés (120) à des lignes de montage (110) selon des consignes définies grâce à une programmation linéaire en nombres entiers,
- dans lequel les consignes définies stipulent qu'en raison de restrictions techniques, les cartes de circuits imprimés (120) ne peuvent pas toutes être montées sur chaque ligne de montage (110), que des temps de production différents sont la plupart du temps alloués aux cartes de circuits imprimés sur les lignes de montage (110) et que les capacités maximales en matière de temps de production des lignes de montage (110) ne doivent pas être dépassées,
- dans lequel l'affectation (315) comprend :

- la détermination d'une affectation de départ de cartes de circuits imprimés (120) sur des lignes de montage (110),
- la sélection d'un sous-ensemble de cartes de circuits imprimés (120) parmi les cartes de circuits imprimés (120) à affecter,
- des sous-ensembles différents étant sélectionnés lors de cycles successifs du procédé (200) ;
- l'affectation (315) des cartes de circuits imprimés (120) du sous-ensemble aux lignes de montage (110) grâce à une programmation linéaire en nombres entiers, de façon que la somme des variances des composants des lignes de montage (110) soit minimisée,
- dans lequel la variance des composants d'une ligne de montage (110) est définie par le nombre de composants (155) différents qui doivent être montés sur les cartes de circuits imprimés (120) qui sont affectées à la ligne de montage (110) ;

- dans lequel le dispositif de commande (115) est en outre conçu pour déterminer des familles d'équipement pour les lignes de montage (110) sur la base de l'affectation, une famille d'équipement étant définie comme une quantité de cartes de circuits imprimés (120) qui peuvent être montées sur une ligne de montage (110) sans changer la quantité des types de composants qui sont tenus à disposition pour le montage au niveau de la ligne de montage (110), et
- pour procéder à une nouvelle affectation (325) jusqu'à ce qu'un critère ait atteint un seuil prédéfini, le critère étant formé sur la base des nombres de familles d'équipement des lignes de montage (110),
- dans lequel le critère comprend au moins une des conditions suivantes :

- que le nombre de familles d'équipement de chaque ligne de montage (110) soit supérieur à un premier seuil prédéfini,
- que le nombre de familles d'équipement de chaque ligne de montage (110) soit inférieur à un second seuil prédéfini, et
- que les différences entre les nombres de familles d'équipement de chaque ligne de montage (110) se situent en-dessous d'un seuil prédéfini, et

- pour équiper les cartes de circuits imprimés (120) sur les lignes de montage (110) respectivement affectées.

FIG 1

FIG 2

# FIG 3

300

305

310

315

320

325

330

335

345

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 102009013353 B3
- EP 0478361 A1
- EP 0478360 A1

### In der Beschreibung aufgeführte Nicht-Patentliteratur

- **HANS-OTTO GÜNTHER et al.** Workload planning in small lot printed circuit board assembly. *OR Spectrum,* 01. Juni 1997, vol. 19 (2), 147-157